# EUROPEAN PATENT APPLICATION

(11) **EP 2 314 872 A1**
(43) Date of publication of application: **27.04.2011**
(21) Application number: 09013247.3
(22) Date of filing: 20.10.2009
(51) Int. Cl.: F03G 7/06, H01L 35/28

(54) **Energy generating system and method for generating electrical energy at a seabed**

(71) Applicant: SIEMENS AKTIENGESELLSCHAFT, 80333 München (DE)
(72) Inventor: Bø, Ove, 7549 Tanem (NO)

(57) **Abstract**

The invention relates to an energy generating system (1) for generating electrical energy at a seabed (10), **characterized in that** the energy generating system (1) comprises a canister (2) arranged at the seabed (10), whereby in the canister (2) at least one electrothermal converter (3) is in contact with a cooling surface (4) and a heating surface (5), whereby the cooling surface (4) is cooled by the circumjacent seawater, a pipeline (6) with a pump (7) for feeding a hot medium out of a drilling well (11) in the seabed (10) to heat up the heating surface (5), and a power output (8) in the canister (2) for the electrical energy generated by the at least one electrothermal converter (3). The invention relates further to a method for generating electrical energy at a seabed (10) for providing underwater installations with electrical energy, where such an energy generating system (1) is used.

## Description

The present invention relates to an energy generating system for generating electrical energy at a seabed and to a method for generating electrical energy at a seabed for providing underwater installations with electrical energy.

For the exploration of subsea oil or gas fields, the installations need large amounts of secure energy both for control and power systems. For example, the installations can be drills, pumps or control units. Up to now the subsea installations have been fed by cable connections from a platform or a similar topside installation with a local power generation. Energy supply by the means of cable connections from the coastline is also an alternative. Depending on the depth of the seabed very long cables are necessary. Long cables are expensive and bear the risk of damages or losses.

It is therefore an object of the invention to improve the power supply for installations at the seabed.

The object of the invention is solved by an energy generating system for generating electrical energy at a seabed with the features according to claim 1 and by a method for generating electrical energy at a seabed with the features according to claim 15. Advantages, features, details, aspects and effects of the invention arise from the dependent claims, the description and the figures. Features and details which are described in connection with the energy generating system count as well for the method for generating electrical energy, and vice versa.

According to a first aspect of the present invention the object is solved by an energy generating system for generating electrical energy at a seabed, whereby the energy generating system comprises a canister arranged at the seabed, whereby in the canister at least one electrothermal converter is in contact with a cooling surface and a heating surface, whereby the cooling surface is cooled by the circumjacent seawater, a pipeline with a pump for feeding a hot medium out of a drilling well in the seabed to heat up the heating surface, and a power output in the canister for the electrical energy generated by the at least one electrothermal converter.

The energy generating system is advantageously arranged directly at the seabed, near to a hot medium in the seabed. Further, the energy generating system is placed close to an oil or gas field which is to be explored or exploited to provide the necessary installations with electrical energy. The hot medium in the seabed can be the oil or the gas itself or a geothermal energy source, e.g. a hot fluid like hot steam or hot water. The canister is arranged at the seabed. In the canister is at least one electrothermal converter arranged. An electrothermal converter according to the invention is a unit which can generate a current flow because of a temperature difference. The canister is advantageously a closed canister, so that the at least one electrothermal converter is protected from the circumjacent seawater and the pressure at the seabed. Advantageously, the at least one electrothermal converter has big dimension or there are a couple of electrothermal converter arranged in the canister. The canister can be a box, a tank or a container, in which the at least one electrothermal converter is fixed. Two or more electrothermal converters are advantageously connected in series.

The canister comprises a cooling surface and a heating surface. The at least one electrothermal converter is in contact both with the cooling surface and the heating surface. It is possible that two or more cooling surfaces and/or two or more heating surfaces are provided. The at least one cooling surface is cooled - directly or indirectly via a further fluid - by the circumjacent seawater. The at least one heating surface is heated up by the hot medium coming out of the seabed or by a fluid that got heated up itself by the hot medium coming out of the seabed. To guide the hot medium to the at least one heating surface a pipeline is arranged from a drilling well to the heating surface.

The at least one electrothermal converter in the canister of the energy generating system comprises advantageously one or more thermocouples. The electrothermal converter generates a current flow because of the Seebeck-effect. The Seebeck-effect is the conversion of temperature differences directly into electricity. The effect is that a voltage is created in the presence of a temperature difference between two different metals or semiconductors. This causes a continuous current in the conductors if the metals form a complete loop.

The energy generating system comprises a power output in the canister, in particular in the wall of the canister, for the electrical energy generated by the at least one electrothermal converter. The generated electrical energy can be provided for adjacent installations, like control or power systems.

The energy generating system is based on making use of locally available high temperature differences to generate electrical power locally. In this way the costs for a long power and communications cable, respectively, can be saved. Also limitations to step out lengths of step out cables due to transmission limitations such as cable losses etc. can be avoided.

To establish a high temperature difference, hot and cold media are used. The source for cold media will normally be the surrounding seawater. This may be arranged by direct use of cold seawater as a cooling medium. The cold seawater cools the at least one cooling surface in the canister, which cools a first junction of a thermocouple. The source for the high temperature medium can be the well stream itself. In many oilfields, oil and gas from the well have a very high temperature. This thermal energy may be the source for generation of electrical energy. The hot medium heats up the at least one heating surface in the canister, which heats up a second junction of the thermocouple. If oil or gas may directly heat up the second junction of the thermocouple. Or a further fluid may be heated by the hot oil or gas, so that the further fluid heats up the second junction of the thermocouple.

The source for the high temperature medium may be a fluid picking up the high temperature present in the deeper layers of the sea. In this case the geothermal energy of a geothermal field is used for heating up the heating surface. Therefore an energy generating system is preferred, which uses as hot medium the oil or gas coming from an oil field and a gas field, respectively, or a geothermal energy coming from a geothermal field.

One advantage of such an energy generating system lies in the use of locally available thermal energy in the seabed for electrical power generation.

According to an advantageous development of the invention an energy generating system is provided, whereby the cooling and/or the heating surface is/are part of the canister wall. In particular the at least one cooling surface can be part of the canister wall. This enables the circumjacent seawater to cool down at least one cooling surface. Thereby the circumjacent seawater is in direct contact to the at least one cooling surface. The cooling surface can be a part of the wall at one side of the canister. The at least one heating surface can be a part of the wall of the canister, as well. The pipeline can be constructed in such a way that the hot medium is in direct or indirect contact to the at least one heating surface. The pipeline can be thin-walled in the contact area to the at least one heating surface.

In a further preferred embodiment the energy generating system is characterized in that the canister has an inlet, a duct and an outlet for guiding a seawater flow along the cooling surface inside the canister and/or that the canister has an inlet, a duct and an outlet for guiding the hot medium along the heating surface inside the canister. If the at least one cooling surface is arranged inside the canister, which is the preferred embodiment of the energy generating system, the seawater may flow through the canister to get in contact with the at least one cooling surface. Therefore it is advantageous when the canister comprises at least an inlet, at least a duct and at least an outlet for guiding a seawater flow along the at least one cooling surface inside the canister.

The canister can have as well an inlet, a duct and an outlet for guiding the hot medium along the heating surface inside the canister. One end of the pipeline can be connected to the inlet, so that the hot medium coming through the pipeline flows in the duct for heating the at least one heating surface inside the canister. Another pipeline can be connected to the outlet of the canister and the hot medium can be lead back to the seabed. In a very preferred embodiment of the energy generating system the pipeline is a closed loop. That means the pipeline has the function of a heat exchanger. In the pipeline is a fluid. This fluid is pumped by a pump, in this case a circulation pump, through the pipeline. In the drilling well the fluid is heated up. The very hot fluid is pumped to the energy generating system for heating up the at least one heating surface. The slightly chilled fluid is led back to this part of the pipeline which is placed near the hot medium in the seabed, like the oil, the gas or a geothermal energy source, where it is heated up again. Using this kind of pipeline has the advantage that the seawater in the surrounding of the canister is not heated up by an exhausting hot medium.

According to a further advantageous development of the invention an energy generating system is provided, whereby a heat exchanger with a fluid inside for cooling the cooling surface is provided, whereby a first part of the heat exchanger is placed outside the canister and a second part of the heat exchanger is placed inside the canister to be in contact with the cooling surface. The heat exchanger can have the form of a closed pipeline with a cooling fluid inside the pipeline, which is guided through the canister to cool down the at least one cooling surface inside the canister. The fluid in that part of the heat exchanger which is placed outside the canister is cooled down by the circumjacent seawater and then guided to the cooling surface in the canister. To increase the flow of the fluid inside the heat exchanger a circulation pump can be provided. Alternatively or additional to that an energy generating system is preferred, whereby a heat exchanger with a fluid inside for heating the heating surface is provided, whereby a first part of the heat exchanger is in contact with the pipeline and a second part of the heat exchanger is in contact with the heating surface. The fluid inside that part of the heat exchanger, which is in contact with the pipeline, is heated up by the hot medium in the pipeline. The heated up fluid flows through the heat exchanger to the at least one heating surface inside the canister for heating up the at least one heating surface. After heating up the heating surface the temperature of the fluid decreases, till it is heated up again by the hot medium in the pipeline. The second heat exchanger can have the form of a closed pipeline with a heating fluid inside the pipeline. To increase the flow of the fluid inside the second heat exchanger a circulation pump can be provided.

Further, an energy generating system is preferred, which is characterized in that it comprises at least one energy storage element, e.g. a battery, in particular placed inside the canister, and/or that it comprises a communication cable or an adapter for a communication cable to provide a small amount of startup energy to the energy generating system. The at least one battery can be arranged outside the canister or inside the canister. Preferred is a canister with a least one battery inside the canister. This has the advantage that the at least one battery is protected by the same canister. No additional inlets or connections are necessary in the wall of the canister, which have to be sealed. The at least one battery can store the startup energy for starting the energy generating system. This energy may be preliminarily stored in the at least one battery or similar devices to assure a sufficient short tile power necessary for startup purposes. The at least one battery can be a rechargeable battery or a capacitor.

Alternatively or additional to the at least one battery the energy generating system can comprise a communication cable or an adapter for a communication cable to provide a small amount of startup energy to the energy generating system. Through the communication cable a small amount of electrical energy can be supplied to the energy generating system to get the system started. In special cases a remotely operated vehicle can connect a cable from a topside power source like a supply ship or similar to provide the startup power.

According to a further advantageous development of the invention an energy generating system is provided, whereby the energy generating system is connected to at least one further energy generating system. By connecting more energy generating systems in a grid the probability of a total blackout can be reduced and at least one energy generating system can provide the startup power for the other energy generating systems. The energy generating systems can be connected with each other by communications cables.

Advantageously one low power energy generating system can be used for providing the other, larger energy generating systems with a small amount of electrical energy to get the system started. The low power energy generating system can advantageously run nonstop.

Preferred is an energy generating, whereby the hot medium is oil or gas coming from an oil field and a gas field, respectively, or a geothermal energy coming from a geothermal field. It is advantageous when two or more drilling wells are provided, so that the pipeline can be guided into a first drilling well, through the hot medium in the energy field to a second drilling well, where the pipeline is guided out of the seabed to the energy generating system.

In a very preferred embodiment of the energy generating system, the energy generating system is characterized in that the at least one electrothermal converter comprises one or more Peltier-element(s). The Peltier element is used as an electrothermal generator. The temperature difference on the two sides, coming from the cooling surface and the heating surface, of the Peltier element generates an electrical power, which can be used to drive electronic circuits. A Peltier element provides two parallel ceramic plates between which a large number of so called peltier pellets are located. These pellets are made of semiconductor materials and contain rather exotic materials as Indium, Bismuth and Tellurium. When different temperatures are applied at the ceramic plates, an electric current flow is generated by the pellets. The thermoelectric effect is the direct conversion of temperature differences to electric voltage. A thermoelectric device creates a voltage when there is a different temperature on each side. The Peltier element creates a voltage when there is a different temperature on each side.

Modern Peltier elements are made from alternating p-type and n-type semiconductor elements connected by metallic interconnects. Semiconductor junctions are especially common in power generation devices. Charge flows through the n-type element, crosses a metallic interconnect, and passes into the p-type element. If a heat source, the heating surface, is provided, the Peltier element may function as a power generator. The heat source will drive electrons in the n-type element toward the cooler region, thus creating a current through the circuit. Holes in the p-type element will then flow in the direction of the current. The current can then be used to power a load, thus converting the thermal energy into electrical energy.

According to a further advantageous development of the invention an energy generating system is provided, whereby the pressure inside the canister is 1 atm - the standard atmosphere and roughly 1 bar - or around 1 atm or around 1 bar. Preferably the inside of the canister is filled with a fluid and exposed to the same pressure as the external seawater. In case some components can not withstand the pressure of the external seawater, they have to be installed in a pressure resistant canister with 1 atm internal pressure. The advantage by a pressure exposed energy generating system is that the walls of the canister and all penetrations in the canister wall do not have to withstand the high differential pressure between the external seawater pressure at the seabed and 1 atm internal pressure.

In a further preferred embodiment the energy generating system comprises a power converter for converting the generated electrical energy from direct current into alternating current. The at least one Peltier element and the at least one electrothermal generator, respectively, generate a direct current, so called DC. For transforming the DC voltage to AC voltage subsea power converters will be needed. The power converters can be used to generate AC voltage for further distribution or for feeding motors and consumers directly.

According to a second aspect of the invention the object is solved by a method for generating electrical energy at a seabed for providing underwater installations with electrical energy, characterized in that the electrical energy is generated by at least one energy generating system according to the first aspect of the invention. A hot medium is been fed by a pump, which can be a circulation pump, out of a drilling well in a seabed through a pipeline to heat up a heating surface, which is arranged in a canister placed at the seabed and which is in contact with at least one electrothermal converter. The hot medium, like oil, gas or a geothermal energy, is used for heating up the heating surface, which is in contact with the at least one electrothermal converter. On the other hand the circumjacent seawater is used for cooling a cooling surface, which is also in contact with the at least one electrothermal converter. The at least one cooling surface and the at least one heating surface conduct the cooling energy and the heating energy to two different junctions of the at least one electrothermal converter. Because of the temperature difference at the junctions the at least one electrothermal converter generates a current flow, which can be used for subsequent installations, like control and/or power systems. The generated direct current can be converted by one or more power converters into alternating current.

Further, a method is preferred, whereby a battery, a further energy generating system or a communication cable to a topside power source or to a power source of a remotely operated vehicle provides a small amount of startup energy to the energy generating system.

The invention is based on making use of locally available high temperature differences to generate electrical power at a seabed. The energy generating system and the method for generating electrical energy at a seabed can save costs, because no long power cable has to be used. Also limitations to step out lengths due to transmission limitations such as cable losses etc. can be avoided.

The invention may provide energy for startup of components used in oil or gas drilling processes. Furthermore the invention may also be used for providing energy for an emergency shutdown, so that equipment on or in the seabed may be switched off in a controlled manner. A further system to which the application can be applied to is a self-sufficient monitoring system on the seabed, so that energy is provided to a monitoring system for monitoring e.g. a drilling process without the need of additional energy supply.

Further features, properties and advantages of the present invention will become clear from the following description of embodiments of the invention in conjunction with the accompanying drawings, in which:
- Figure 1: shows in a schematic view a first embodiment of an energy generating system at a seabed;
- Figure 2: shows in a schematic view a second embodiment of an energy generating system at a seabed.

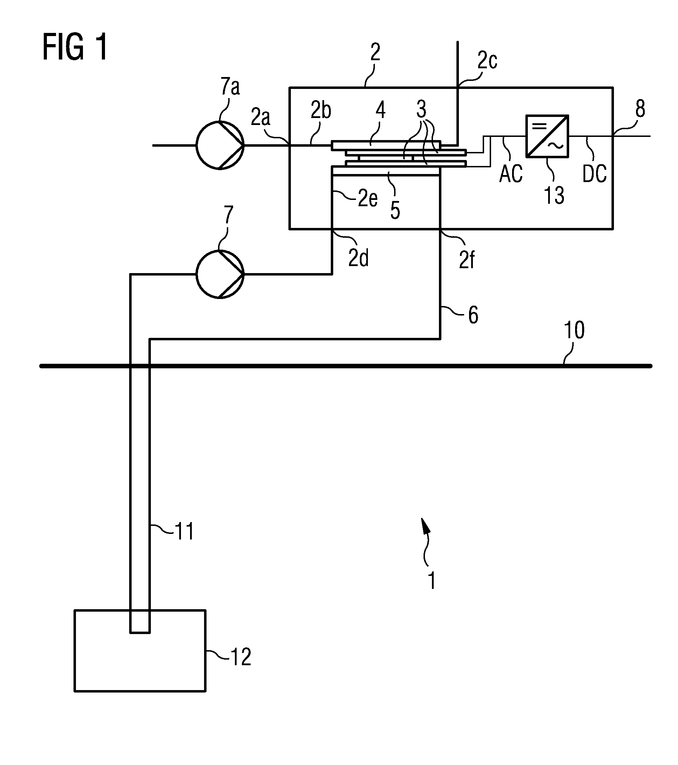

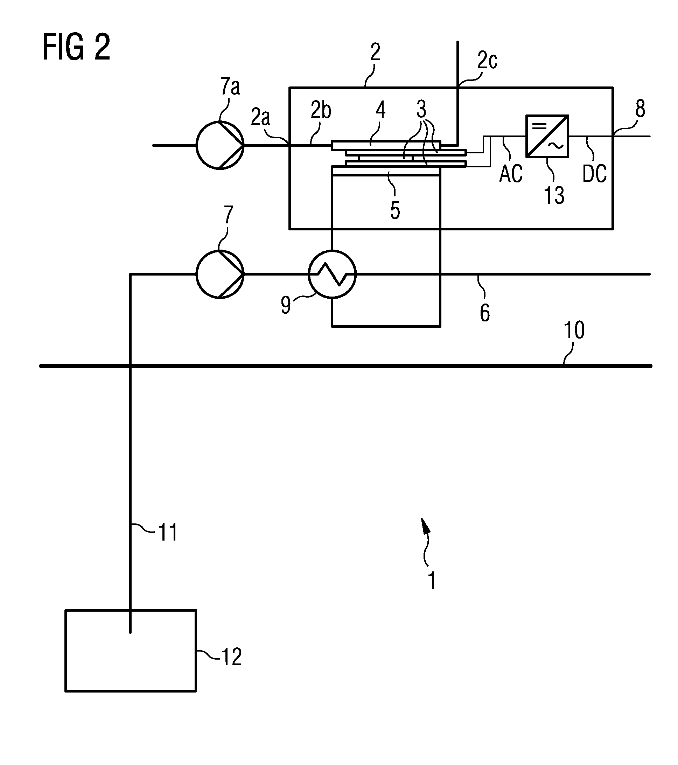

Elements with the same function and mode of operation are provided in the fig. 1 and 2 with the same references.

Fig. 1 shows schematically a first embodiment of an energy generating system 1 at a seabed 10. The energy generating system 1 comprises a canister 2 arranged at the seabed 10. In the canister 2 is at least one electrothermal converter 3 arranged. The electrothermal converter 3 is a unit which can generate a current flow because of a temperature difference. The electrothermal converter 3 is in contact with a cooling surface 4 and a heating surface 5. The cooling surface 4 is cooled by the circumjacent seawater. The energy generating system 1 comprises further a pipeline 6 with a pump 7 for feeding a hot medium out of a drilling well 11 in the seabed 10 to heat up the heating surface 5. Further the energy generating system 1 comprises a power output 8 in the canister 2 for the electrical energy generated by the at least one electrothermal converter 3. The generated electrical energy can be provided for subsequent installations, like control or power systems.

The energy generating system 1 is arranged directly at the seabed 10, near to a hot medium in the seabed 10, to use the hot medium. Therefore the pipeline 6 does not need to be very long. Advantageously the hot medium is oil, gas or a geothermal energy coming from an oil, gas or geothermal energy field 12.

The canister 2 is advantageously a closed canister 2, so that the at least one electrothermal converter 3 is protected from the circumjacent seawater and the pressure at the seabed 10. The canister 2 is a box, a tank or a container, in which the at least one electrothermal converter 3 is arranged. Advantageously, there are two or more electrothermal converters 3 connected in series.

The canister 2 comprises at least one cooling surface 4 and at least one heating surface 5. The at least one cooling surface 4 and the at least one heating surface 5 can be part of the canister wall. Advantageously the at least one cooling surface 4 and the at least one heating surface 5 are arranged inside the canister 2. The at least one electrothermal converter 3 is in contact both with the at least one cooling surface 4 and the at least one heating surface 5. The cooling surface(s) 4 is/are cooled by the circumjacent seawater. The heating surface(s) 5 is/are heated up by the hot medium coming out of the seabed 10. To guide the hot medium to the at least one heating surface 5 the pipeline 6 is arranged from a drilling well 11 to the heating surface 5.

The energy generating system 1 comprises a power output in the canister 2, in particular in the wall of the canister 2, for the electrical energy generated by the at least one electrothermal converter.

The energy generating system 1 is based on making use of locally available temperature differences at the seabed 10 to generate electrical power. In this way the costs for a long cable from an energy source based at the coastline or on a platform on the water surface can be saved.

In Fig. 1 the seawater is guided through the canister 2 to cool down the at least one cooling surface 4 inside the canister 2. Therefore the canister 2 comprises an input 2a, a duct 2b and an output 2c. At least a part of the duct 2b has contact to the at least one cooling surface 4. A pump 7a feeds the seawater through the canister 2. The pipeline 6 is in this embodiment of the energy generating system 1 a closed loop. In the pipeline 6 flows a medium, in particular a fluid, which is heated up during the passage through the hot energy field 12. A pump 12, in this case a circulation pump, feeds the hot medium to the canister 2. The hot medium flows through an input 2d, a duct 2e and an output 2f through the canister 2. At least a part of the duct 2e is in contact with the at least one heating surface 5. The hot medium heats up the at least one heating surface 5. A circulation pump 7 enables the circulation of the medium inside the pipeline 6.

The at least one cooling surface 4 in the canister 2 cools down a first junction of the electrothermal converter 3, which comprises a thermocouple, in particular a Peltier element. The at least one heating surface 5 in the canister 2 heats up a second junction of the electrothermal converter 3.

The energy generating system 1 comprises further a power converter 13 for converting the generated electrical energy from direct current (DC) into alternating current (AC).

Fig. 2 shows schematically a second embodiment of an energy generating system 1 at a seabed 10. In contrast to the embodiment of the energy generating system 1 described in Fig. 1, the pipeline 6 does not flow through the canister 2. A pump 7 feeds a hot medium, in particular oil or gas, through the pipeline 6. The pipeline 6 is in contact with a heat exchanger 9. In the heat exchanger 9 circulates a fluid in a close loop. The fluid in the heat exchanger 9 is heated up by the hot medium in the pipeline 6. The hot fluid heated by the heat exchanger 9, is routed to the heating surface 5 to heat up the at least one heating surface 5 inside the canister 2.

The oil or gas in the pipeline 6 is not lead back to the oil or gas field 12, but used for other purposes, e.g. oil or gas recovery.

### Reference numeral list

- 1: energy generating system
- 2: canister
- 2a: inlet for seawater
- 2b: duct for seawater
- 2c: outlet for seawater
- 2d: inlet for hot medium
- 2e: duct for hot medium
- 2f: outlet for hot medium
- 3: electrothermal converter
- 4: cooling surface
- 5: heating surface
- 6: pipeline
- 7: pump
- 7a: pump
- 8: power output
- 9: heat exchanger
- 9a: first part of heat exchanger
- 9b: second part of heat exchanger
- 10: seabed
- 11: drilling well
- 12: oil field, gas field or geothermal field
- 13: power converter

- DC: direct current
- AC: alternating current

## Claims

1. Energy generating system (1) for generating electrical energy at a seabed (10), **characterized in that** the energy generating system (1) comprises a canister (2) arranged at the seabed (10), whereby in the canister (2) at least one electrothermal converter (3) is in contact with a cooling surface (4) and a heating surface (5), whereby the cooling surface (4) is cooled by the circumjacent seawater, a pipeline (6) with a pump (7) for feeding a hot medium out of a drilling well (11) in the seabed (10) to heat up the heating surface (5), and a power output (8) in the canister (2) for the electrical energy generated by the at least one electrothermal converter (3).

2. Energy generating system (1) according to claim 1, **characterized in that** one electrothermal converter (3) comprises one or more thermocouple(s).

3. Energy generating system (1) according to claim 1 or 2, **characterized in that** the cooling (4) and/or the heating surface (5) is/are part of the canister wall.

4. Energy generating system (1) according to claim 1 to 3, **characterized in that** the canister (2) has an inlet (2a), a duct (2b) and an outlet (2c) for guiding a seawater flow along the cooling surface (4) inside the canister (2) and/or that the canister (2) has an inlet (2d), a duct (2e) and an outlet (2f) for guiding the hot medium along the heating surface (5) inside the canister (2).

5. Energy generating system (1) according to at least one of the claims 1 to 3, **characterized in that** a heat exchanger with a fluid inside for cooling the cooling surface (4) is provided, whereby a first part of the heat exchanger is placed outside the canister (2) and a second part of the heat exchanger is placed inside the canister (2) to be in contact with the cooling surface (4).

6. Energy generating system (1) according to at least one of the claims 1 to 5, **characterized in that** a heat exchanger (9) with a fluid inside for heating the heating surface (5) is provided, whereby a first part (9a) of the heat exchanger (9) is in contact with the pipeline (6) and a second part (9b) of the heat exchanger (9) is in contact with the heating surface (5).

7. Energy generating system (1) according to at least one of the claims 1 to 6, **characterized in that** the energy generating system (1) comprises at least one battery, in particular placed inside the canister (2), and/or the energy generating system (1) comprises a communication cable or an adapter for a communication cable to provide a small amount of startup energy to the energy generating system (1).

8. Energy generating system (1) according to at least one of the claims 1 to 7, **characterized in that** the energy generating system (1) is connected to at least one further energy generating system.

9. Energy generating system (1) according to at least one of the claims 1 to 8, **characterized in that** the pipeline (6) is a closed circuit.

10. Energy generating system (1) according to at least one of the claims 1 to 9, **characterized in that** the hot medium is oil or gas coming from an oil field and a gas field (12), respectively, or a geothermal energy coming from a geothermal field (12).

11. Energy generating system (1) according to at least one of the claims 1 to 10, **characterized in that** the at least one electrothermal converter (3) comprises one or more Peltier-element (s).

12. Energy generating system (1) according to one of the claims 1 to 11, **characterized in that** the pressure inside the canister (2) is equal to the standard atmosphere or around 1 bar.

13. Energy generating system (1) according to one of the claims 1 to 11, **characterized in that** the canister (2) is filled with a fluid and exposed to the pressure of the seawater at the seabed.

14. Energy generating system (1) according to one of the claims 1 to 13, **characterized in that** the energy generating system (1) comprises a power converter (13) for converting the generated electrical energy from direct current (DC) into alternating current (AC).

15. Method for generating electrical energy at a seabed (10) for providing underwater installations with electrical energy, **characterized in that** the electrical energy is generated by at least one energy generating system (1) according to at least one of the claims 1 to 14.

16. Method for generating energy at a seabed (10) according to claim 15, **characterized in that** a hot medium is been fed by a pump (7) out of a drilling well (11) in a seabed (10) through a pipeline (6) to heat up a heating surface (5), which is arranged in a canister (2) placed at the seabed (10) and which is in contact with the at least one electrothermal converter (3), that circumjacent seawater is used for cooling a cooling surface (4), which is in contact with the at least one electrothermal converter (3), and that the at least one electrothermal converter (3) generates a current flow because of a temperature difference in the at least one electrothermal converter (3), as a result of a contact of the at least one electrothermal converter (3) to the cooling surface (4) and the heating surface (5).

17. Method for generating energy at a seabed (10) according to claim 15 or 16, **characterized in that** a battery, a further energy generating system or a communication cable to a topside power source or to a power source of a remotely operated vehicle provides a small amount of startup energy to the energy generating system (1).
